# EUROPEAN PATENT SPECIFICATION

(11) **EP 3 318 658 B1**
(45) Date of publication and mention of the grant of the patent: **05.01.2022**
(21) Application number: 15897078.0
(22) Date of filing: 30.09.2015
(51) Int. Cl.: H01J 37/32, C23C 16/44, C23C 16/04, B65D 23/02, C23C 16/509, C23C 16/455

(54) **FILM FORMING DEVICE AND FILM FORMING METHOD**
FILMBILDUNGSVORRICHTUNG UND FILMBILDUNGSVERFAHREN
DISPOSITIF ET PROCÉDÉ DE FORMATION DE FILM

(30) Priority: 30.06.2015 JP 2015130508
(43) Date of publication of application: 09.05.2018
(73) Proprietor: Mitsubishi Heavy Industries Machinery Systems, Ltd., Hyogo-ku, Kobe-shi Hyogo 652-8585 (JP)
(72) Inventor: MIZUKAWA, Kenji, Kobe-shi Hyogo 652-0863 (JP); HIROYA, Kiyoshi, Kobe-shi Hyogo 652-0863 (JP); NAKANISHI, Fumikazu, Kobe-shi Hyogo 652-0863 (JP)
(74) Representative: Hoffmann Eitle
(86) International application number: PCT/JP2015/004983
(87) International publication number: WO 2017/002151

(56) References cited:
- EP-A1- 2 799 593
- WO-A1-95/21948
- WO-A1-2006/126677
- WO-A1-2013/099960
- JP-A- 2005 076 082
- JP-A- 2013 133 494

## Description

### Technical Field

The present invention relates to a film forming device that is suitable for formation of a gas barrier film in a resin container.

### Background Art

A resin container is provided with a gas barrier film on an inner peripheral surface. The gas barrier film is formed for some purposes. For example, the gas barrier film aims at preventing oxygen from being transmitted from the outside of the container to secure quality of product liquid filled in the container. The gas barrier film also aims at preventing carbon dioxide contained in a carbonated beverage from being transmitted to the outside through the container.

Various gas barrier films (hereinafter, referred to as the barrier films) such as a hard carbon film made of diamond like carbon (DLC) and a silica (SiO₂) film have been proposed, as disclosed in Patent Literature 1 and Patent Literature 2.

Such barrier films are formed through various methods represented by a chemical vapor deposition (CVD) method. Typical examples of the CVD method include a plasma CVD method (Patent Literature 1). In the plasma CVD method, medium gas as a raw material is decomposed and ionized by plasma in a film forming chamber in a vacuum state, and ions are accelerated by an electric field to perform collision, thereby forming a film.

As another CVD method other than the plasma CVD method, a catalytic chemical vapor deposition (Cat-CVD) method disclosed in Patent Literature 2 is also well-known. In the Cat-CVD method, medium gas is decomposed on a surface of a linear catalyst that is energized and heated in a film forming chamber, and generated chemical species are deposited to form a film after a direct reaction process or a reaction process in gas phase. The Cat-CVD method is also referred to as a heater CVD method or a hot wire CVD method.

Patent Literature 3 relates to a film formation apparatus for forming thin films having high gas barrier performance, such as a DLC (Diamond Like Carbon) film, SiOx film, SiOC film, SiOCN film, SiNx film, and AlOx film, on the inner surface and/or outer surface of containers such as PET bottles.

Patent Literature 4 relates to a plasma assisted deposition of a very thin inner surface coating inside a plastic or metal container achieved using insoluble, inert, inorganic substances such as silica, or insoluble metal oxides, or by using mixtures of substances, for example of metals, metal oxides, metal salts and carbon and/or organic radicals, so as to form a flexible structure or a lattice, or by using different layers of such structures.

### Citation List

### Patent Literature

Patent Literature 1: Japanese Patent Laid-Open No. 2008-231468
Patent Literature 2: International Publication No. WO2012-91097
Patent Literature 3: European Publication No. EP 2799593 A1
Patent Literature 4: International Publication No. WO 95/21948

### Summary of Invention

### Technical Problem

To form the barrier film on the inner surface of the container by the above-described CVD method, it is necessary to introduce the medium gas into the container that is housed in a film forming chamber in a vacuum state. Therefore, a gas supply pipe that conducts the medium gas into the container is inserted into the container before the film formation, and the gas supply pipe is pulled out from the container after the film formation treatment is completed. Accordingly, a time for insertion and pullout of the gas supply pipe is necessary in addition to the time for the film formation in order to form the barrier film in the container. The insertion and pullout of the gas supply pipe takes a time equivalent to the time necessary for a series of steps of forming the barrier film. On the other hand, in consideration of product efficiency, it is desirable to continuously perform the formation of the barrier film on as many containers as possible for a long period.

Therefore, an object of the present invention is to provide a film forming device that makes it possible to reduce the time necessary for the formation of the barrier film in each container and to lengthen a continuous operation time for the formation of the barrier film.

### Solution to Problem

For such a purpose, a film forming device according to the present invention includes the features of claim 1. The gas supply pipe according to the present invention is inserted into the container housed in the film forming chamber, and supplies the medium gas through the gas flow path, in the formation of the gas barrier film. In addition, the gas supply pipe is retracted from the container housed in the film forming chamber and the gas flow path is maintained in a decompression state in a standby time during which the formation of the gas barrier film is not performed.

Here, the film forming chamber is evacuated prior to the film formation. At this time, it is necessary to discharge the gas component contained inside the gas supply pipe inserted into the container. The present invention, however, makes it possible to eliminate or minimize even if necessary, the time necessary for discharge of the gas component because the gas flow path is decompressed and exhausted in the standby time. Accordingly, the present invention makes it possible to reduce the time necessary for the formation of the gas barrier film.

Next, when the chamber is opened to the atmosphere after the barrier film is formed, a component that is deposited inside the gas supply pipe and the vacuum chamber in the film formation and is equivalent to the component of the barrier film may come off as particles, and the particles may enter and block the gas flow path. According to the present invention, however, since the gas flow path maintains the vacuum state in the standby time, the particles as peeled pieces do not enter the gas flow path. Consequently, the present invention makes it possible to reduce frequency of maintenance with respect to blocking of the gas supply pipe, and to ensure continuous operation for a long period.

The film forming device according to the present invention may include a decompression chamber that communicates with the gas flow path of the gas supply pipe in the standby time. The film forming device makes it possible to maintain the gas flow path in a decompression state by decompression of the decompression chamber.

The film forming device according to the present invention includes a housing that includes the decompression chamber in which the gas supply pipe is moved up and down, and is supported by the chamber. The gas supply pipe may be inserted into or pulled out from the container through the chamber.

The film forming device according to the present invention may include a shield valve that blocks communication between the film forming chamber and the decompression chamber when the gas supply pipe is retracted from the film forming chamber.

The film forming device according to the present invention is applicable to any of the plasma CVD method and the Cat-CVD method.

When being applied to the Cat-CVD method, the film forming device according to the present invention includes a heater that is supported by the gas supply pipe, and the heater is inserted into and pulled out from the container, following the insertion and pullout of the gas supply pipe.

Further, when being applied to the plasma CVD method, the film forming device according to the present invention includes an external electrode and an internal electrode. The external electrode is disposed in the chamber and houses the container, and the internal electrode is inserted into and pulled out from the container housed in the external electrode, and conducts the medium gas into the container. The internal electrode constitutes the gas supply pipe.

When the film forming device according to the present invention is applied to the Cat-CVD method, it is possible to continuously supply the medium gas to the film forming chamber through the gas supply pipe for a predetermined time period in the standby time after the formation of the gas barrier film is completed.

Likewise, the film forming device according to the present invention may include a first gas supply source that supplies, to the decompression chamber, gas stable to the formation of the gas barrier film, and it is possible to introduce the stable gas from the decompression chamber into the film forming chamber after the stable gas is supplied from the first gas supply source to the decompression chamber and is stored in the decompression chamber, in the standby time prior to the formation of the gas barrier film. Alternatively, the film forming device according to the present invention may include a second gas supply source that supplies, to the film forming chamber, gas stable to the formation of the gas barrier film, and the second gas supply source may supply the stable gas to the film forming chamber in the standby time prior to the formation of the gas barrier film.

### Advantageous Effects of Invention

According to the present invention, the gas flow path of the gas supply pipe maintains the decompression state in the standby time during which the film formation is not performed. This makes it possible to reduce a time necessary for evacuation of the film forming chamber performed prior to the film formation, and to reduce the time necessary for the formation of the barrier film. In addition, according to the present invention, the gas flow path of the gas supply pipe is maintained in the decompression state in the standby time during which the film formation is not performed. This makes it possible to prevent the gas flow path of the gas supply pipe from being blocked by peeled pieces and to ensure continuous operation for a long period.

### Brief Description of Drawings

[FIGS. 1A and 1B] FIGS. 1A and 1B are vertical cross-sectional diagrams each illustrating a schematic configuration of a film forming device according to a first embodiment.
[FIG. 2] FIG. 2 is a vertical cross-sectional diagram illustrating a sheath and a gas supply pipe in the film forming device of FIGS. 1A and 1B.
[FIGS. 3A to 3C] FIGS. 3A to 3C are cross-sectional diagrams illustrating a bottle feeding step and a chamber closing step in a procedure of FIG. 7.
[FIGS. 4A to 4C] FIGS. 4A to 4C are cross-sectional diagrams illustrating a series of steps of evacuating the chamber in the procedure of FIG. 7.
[FIGS. 5A to 5C] FIGS. 5A to 5C are diagrams illustrating a film forming step, a gas supply pipe retracting step, a gate valve closing step, and a step of opening the inside of the chamber to the atmosphere in the procedure of FIG. 7.
[FIGS. 6A to 6C] FIGS. 6A to 6C are diagrams illustrating a chamber opening step, a bottle discharging step, and a standby step in the procedure of FIG. 7.
[FIG. 7] FIG. 7 is a flowchart illustrating the procedure of forming a barrier film in a container with use of the film forming device according to the present embodiment.
[FIG. 8] FIG. 8 is a vertical cross-sectional diagram illustrating a schematic configuration of a film forming device according to a second embodiment.
[FIG. 9] FIG. 9 is a vertical cross-sectional diagram illustrating a schematic configuration of a film forming device in a first method of a third embodiment.
[FIG. 10] FIG. 10 is a cross-sectional diagram illustrating a schematic configuration of a film forming device in a second method of the third embodiment.
[FIG. 11] FIG. 11 is a vertical cross-sectional diagram illustrating another example of a shield valve in the present embodiment.

### Description of Embodiment

The invention is described in detail below based on an embodiment illustrated in accompanying drawings.

The present embodiment includes a first embodiment and a second embodiment. The first embodiment relates to a film forming device 100 that realizes a film forming method in which a barrier film is formed on an inner surface of a resin container P through a Cat-CVD method. The second embodiment relates to a film forming device 200 that forms a barrier film on the inner surface of the resin container P through a plasma CVD method. The first embodiment and the second embodiment are described in order below.

The film forming devices 100 and 200 are applied to, for example, a system that fills the resin container P with drinking water. As an example, the system may include: a container shaping section that shapes the resin container P; a film forming section that forms a barrier film on an inner peripheral surface of the shaped resin container P; a filling section that fills, with drinking water, a filling space of the resin container in which the barrier film has been formed on the inner peripheral surface; and a capping section that caps the resin container filled with drinking water. In the beverage filling system, each of the container shaping section, the film forming section, the filling section, and the capping section is configured of a rotary mechanism, and a transfer device that transfers the resin container P may be provided between the sections. The film forming device 100, however, may be of a batch system in some cases. The film forming device 100 and the film forming device 200 according to the present embodiment are applicable to the film forming section.

### [First Embodiment]

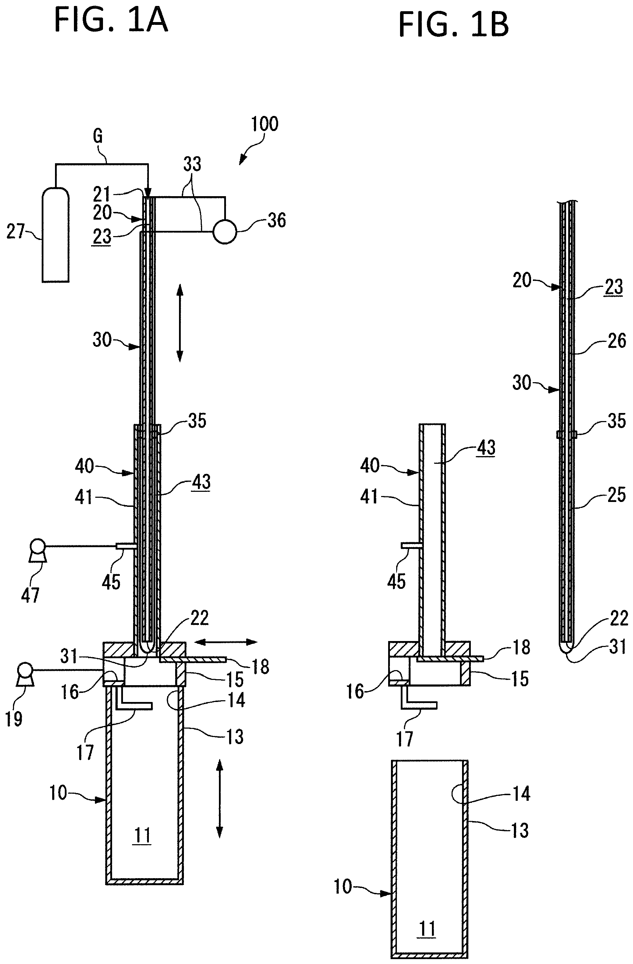

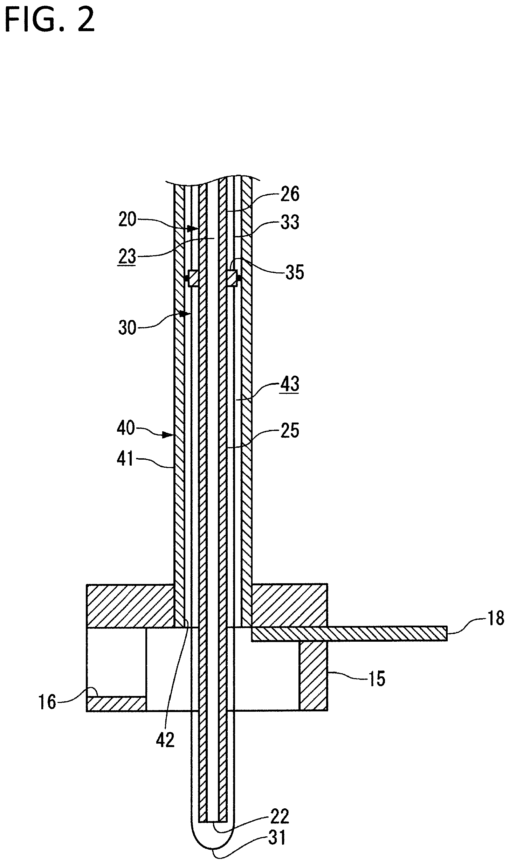

As illustrated in FIGS. 1A, 1B and FIG.2, the film forming device 100 includes, as a main components: a vacuum chamber 10 that houses the unillustrated resin container P; a gas supply pipe 20 that is removably inserted into the resin container P and supplies medium gas to the inside of the resin container P; a heater 30 that is supported by the gas supply pipe 20; and a sheath 40 that houses the gas supply pipe 20 and the heater 30.

Note that both arrows in FIG. 1A indicate operation of respective corresponding members.

The main components of the film forming device 100 are described in order below.

### [Vacuum Chamber 10]

The vacuum chamber 10 includes: a cylindrical lower chamber 13, one end in an axial direction of which is open; and an upper chamber 15 that is detachably mounted on an upper part of the lower chamber 13. In the vacuum chamber 10, an internal space formed by the lower chamber 13 and the upper chamber 15 comprises a film forming chamber 11 that houses the resin container P and forms a barrier film.

In the present embodiment, the resin container P is housed in the lower chamber 13, and the resin container P is carried into and carried out from the lower chamber 13 through, as a gateway 14, an opening that is provided at an upper end of the lower chamber 13. Therefore, the internal space of the lower chamber 13 is so provided as to be slightly larger than an outer shape of the resin container P to be housed therein. When the resin container P has been carried into the lower chamber 13, the upper chamber 15 closes the gateway 14. In addition, the upper chamber 15 opens the gateway 14 at a time when the resin container P is carried into or carried out from the lower chamber 13. Note that, in the present embodiment, the position of the upper chamber 15 in a vertical direction is fixed whereas the lower chamber 13 is moved up and down by an unillustrated actuator; however, the configuration may be reversed from the above as long as the film forming chamber 11 is tightly closed or opened by relative movement of the lower chamber 13 and the upper chamber 15. Note that, to secure a tightly closed state between the lower chamber 13 and the upper chamber 15, a sealing member such as an O-ring may be provided therebetween.

The upper chamber 15 includes an exhaust passage 16. One end of the exhaust passage 16 communicates with the gateway 14 of the lower chamber 13, and the other end thereof is connected to an exhaust pump 19. When the lower chamber 13 and the upper chamber 15 are tightly closed and the exhaust pump 19 is operated, gas components inside the film forming chamber 11 and inside the resin container P are discharged, and a decompression state, more preferably, a vacuum state is established. Note that the decompression state used herein indicates a state with pressure lower than the atmospheric pressure.

The upper chamber 15 includes a gripper 17 that grips the resin container P. The gripper 17 grips a so-called neck part of the resin container P that is conveyed from the upstream step, thereby supporting the resin container P at a predetermined position inside the film forming chamber 11.

The upper chamber 15 supports the sheath 40. One end of the sheath 40 located at lower side penetrates through the upper chamber 15 from a front surface to a rear surface thereof, and fixed to the upper chamber 15. A decompression chamber 43 inside the sheath 40 communicates with the film forming chamber 11. A sliding shield valve 18 is provided in the exhaust passage 16 of the upper chamber 15. The sliding shield valve 18 opens and closes an opening 42 (see FIG. 2) of the sheath 40 that communicates with the film forming chamber 11. When the shield valve 18 is closed, the decompression chamber 43 of the sheath 40 forms a closed space. More specific configuration of the sheath 40 is described later.

A structure that circulates cooling water may be preferably provided on one or both of the inside and the outside of the vacuum chamber 10 to prevent temperature increase of the lower chamber 13 and the upper chamber 15. In particular, the cooling structure may be preferably provided correspondingly to the lower chamber 13. This is because the resin container P into which the heater 30 serving as a heat source in formation of the barrier film is inserted is just housed in the lower chamber 13.

In addition, in the vacuum chamber 10, an inner surface of the lower chamber 13 and an inner surface of the upper chamber 15 that face the film forming chamber 11 may be preferably subjected to treatment for preventing reflection of light that is radiated along with heat generation of the heater 30. It is sufficient for the treatment to paint the inner surfaces in black or to form minutely uneven inner surfaces. This makes it possible to suppress temperature increase of the resin container P.

Note that the material configuring the vacuum chamber 10 is optional as long as the material has predetermined properties such as heat resistance and corrosion resistance, and an aluminum alloy may be suitably used.

### [Gas Supply Pipe 20]

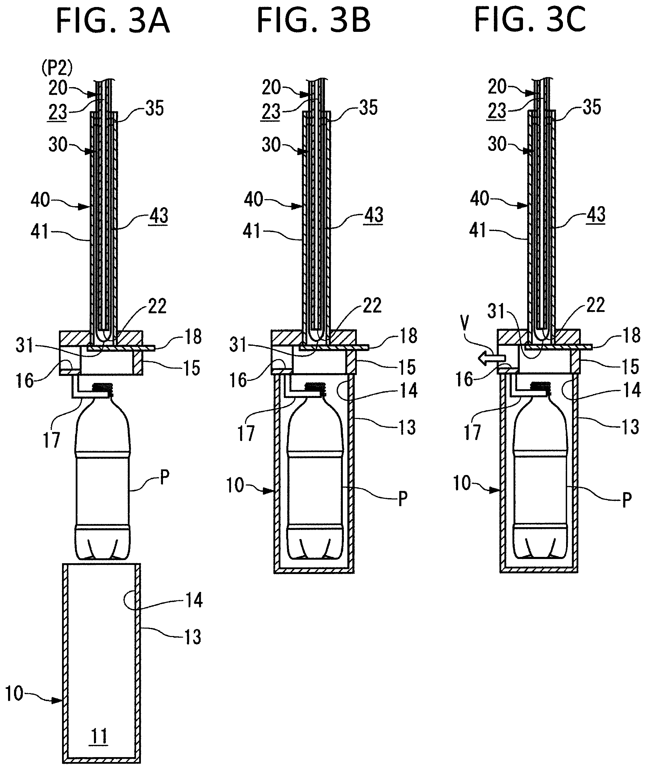

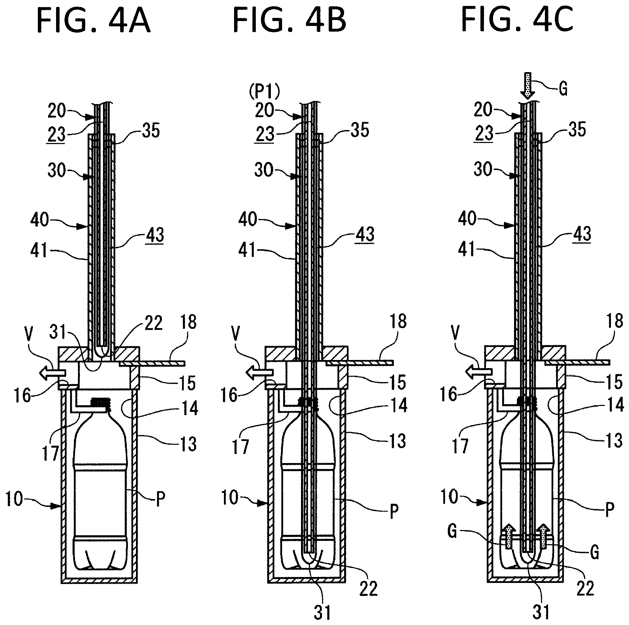

Next, the gas supply pipe 20 conducts medium gas G stored in a raw material tank 27, to the film forming chamber 11 of the vacuum chamber 10. The gas supply pipe 20 is so supported by an unillustrated actuator as to be movable up and down between a film forming position in formation of the barrier film (P1, FIGS. 4B and 4C) and a retracted position in a standby state during which the film formation is not performed (P2, FIGS. 3A to 3C). The gas supply pipe 20 includes a connection end 21 provided at one end and a discharge hole 22 that is provided at the other end. The connection end 21 is connected to the unillustrated material tank 27. The supplied medium gas G is discharged through the discharge hole 22. The medium gas is supplied to the resin container P through a gas flow path 23 that couples the connection end 21 to the discharge hole 22. When the medium gas G is not supplied from the raw material tank 27, the gas supply pipe 20 on the connection end 21 side is sealed.

As illustrated in FIG. 1B and FIG. 2, the gas supply pipe 20 includes: a main region 25 corresponding to the heater 30; and a sub-region 26 other than the main region 25. The main region 25 and the sub-region 26 are arranged along an axial direction. When the gas supply pipe 20 is located at the film forming position P1, the main region 25 is inserted into the resin container P that is housed in the vacuum chamber 10, and the sub-region 26 is housed in the decompression chamber 43 of the sheath 40. In contrast, when the gas supply pipe 20 is located at the retracted position P2, the main region 25 is housed in the decompression chamber 43 of the sheath 40, and the sub-region 26 for the most part is exposed to the outside from the sheath 40. As mentioned above, the main region 25 of the gas supply pipe 20 advances and retreats from the sheath 40 during the relative movement of the gas supply pipe 20 and the sheath 40 in the axial direction.

The gas supply pipe 20 is made of a material having heat resistance and electric insulation property, and is configured of a simple single pipe member. In addition, the gas supply pipe 20 may be integrally formed with a cooling pipe. As the structure, for example, the gas supply pipe 20 is formed in a double pipe structure, an inside of an inner pipe structure serves as a flow path of the medium gas, and a space between the inner pipe structure and an outer pipe structure serves as a flow path of the cooling water.

The gas supply pipe 20 is required to maintain the form without being melted even when the sheath 40 is heated to high temperature exceeding 1000°C, and to have insulating property in order to prevent electrical short circuit with the energized heater 30. A ceramic material meeting the requirement is used for the gas supply pipe 20, and a ceramic material having large thermal conductivity, such as aluminum nitride, silicon carbide, silicon nitride, and aluminum oxide may be preferably used in consideration of cooling property as well. In addition, the material is not limited to the ceramic material, and a metallic material such as stainless steel and super heat-resistant alloy may be used for the gas supply pipe 20. In the case of using the metallic material, the surface may be coated with the above-described ceramic material.

### [Heater 30]

Next, the heater 30 receives the power to generate heat, thereby promoting decomposition of the medium gas supplied from the gas supply pipe 20 into the resin container P.

The heater 30 according to the present embodiment is configured of a linear member. The heater 30 has a U-shaped form including a bent portion 31 below the main region 25 of the gas supply pipe 20, and is supported by the gas supply pipe 20 through an electrically insulating ceramic member 35 above the main region 25. Accordingly, the heater 30 is moved up and down following the operation of the gas supply pipe 20. The U-shaped bent portion 31 of the heater 30 extends up to a position slightly lower than the front end of the gas supply pipe 20. The U-shaped form of the heater 30 is a merely example, and the heater 30 may have other form, for example, a form spirally wound around the outer periphery of the gas supply pipe 20.

A sealing member configured of an O-ring or the like is provided around the ceramic member 35, and the ceramic member 35 is pressed against an inner wall surface of the sheath 40 described later.

The heater 30 is electroconductive, and generates heat in response to energization. In the device illustrated in FIG. 1A, a power supply 36 is connected to the heater 30 through a lead wire 33. A current supplied from the power supply 36 causes the heater 30 to generate heat. The lead wire 33 is made of a material having low electric resistance, and is electrically connected to the heater 30 at a boundary between the main region 25 and the sub-region 26.

The heater 30 in the present embodiment generates heat in response to energization, and heating temperature of the heater 30 is set to 1550°C to 2400°C in order to effectively decompose the medium gas. Therefore, the heater 30 is made of a material that contains one or two or more kinds of metallic elements selected from a group of tungsten (W), molybdenum (Mo), zirconium (Zr), tantalum (Ta), vanadium (V), niobium (Nb), and hafnium (Hf) that are known as high-melting point metals. A pure metal, an alloy, or a carbide of the metal element may be selected as the material, and a material containing one or two or more kinds of metal elements selected from a group of Mo, W, Zr, and Ta is preferable.

Note that, in the present embodiment, the heater 30 generates heat in response to energization; however, a method of causing the heater to generate heat in the present embodiment is not limited to energization heating as long as the heater 30 decomposes the medium gas G.

### [Sheath 40]

The sheath 40 functions as a housing that includes a sheath body 41 and the decompression chamber 43 provided inside the sheath body 41. The sheath 40 stands up on and is supported by the upper chamber 15 along the vertical direction. As described above, a lower part of the sheath body 41 is the opening 42 that penetrates through the upper chamber 15. The gas supply pipe 20 is moved up and down in the decompression chamber 43, thereby being inserted into and pulled out from the film forming chamber 11. At this time, the sheath body 41 guides the up-down movement of the gas supply pipe 20.

The sheath body 41 is provided with an exhaust pipe 45 that causes the decompression chamber 43 to communicate with the outside of the sheath body 41, and the exhaust pipe 45 is connected to an exhaust pump 47. When the exhaust pump 47 is operated while assuming that the ceramic member 35 is pressed against the inner wall surface of the sheath 40 to seal the ceramic member 35 and the sheath 40 and the shield valve 18 is closed, the decompression chamber 43 is brought into a decompression state, preferably into a vacuum state (for example, about 2×10⁻² Torr to about 8×10⁻² Torr). When the gas supply pipe 20 is located at the retracted position P2, the gas flow path 23 communicates with the decompression chamber 43 of the sheath 40. When the decompression chamber 43 is decompressed, the gas flow path 23 is brought into the decompression state.

### [Film Forming Procedure]

Next, an example of a series of procedure that forms a barrier film on the resin container P with use of the film forming device 100 is described with reference to FIG. 3A to FIG. 7.

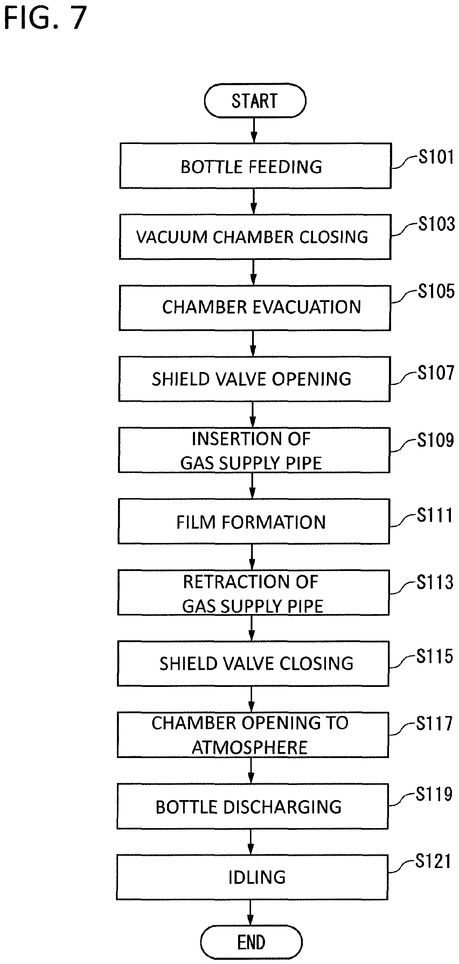

### [Bottle Feeding Step (FIG. 3A and S101 in FIG. 7)]

When the resin container P that has been shaped in the upstream step is conveyed to the film forming device 100, the resin container P is gripped by the gripper 17.

At this time, the lower chamber 13 stands by at a position sufficiently retracted from the upper chamber 15 in order to convey the resin container P to a predetermined position at which the resin container P is gripped by the gripper 17. Further, the gas supply pipe 20 is located at the retracted position P2 retracted from the vacuum chamber 10. In addition, the shield valve 18 closes the opening 42 of the sheath 40, and the decompression chamber 43 forms a closed space except for the exhaust pipe 45.

### [Vacuum Chamber Closing Step (FIG. 3B and S103 in FIG. 7)]

Next, the lower chamber 13 is moved upward, thereby being assembled to the upper chamber 15. This forms the film forming chamber 11 between the lower chamber 13 and the upper chamber 15, and the resin container P to be treated is housed in the film forming chamber 11.

At this time, the gas supply pipe 20 and the shield valve 18 are located at the above-described respective positions.

### [Evacuation Step (FIG. 3C, FIG. 4A, FIG. 4B, and S105 to S109 in FIG. 7)]

Next, the exhaust pump 19 is operated to bring the film forming chamber 11 into the vacuum state for film formation.

The closed shield valve 18 is opened after the exhaust pump 19 is operated (FIG. 4A). The exhaust pump 19 is still operated, and the decompression chamber 43 of the sheath 40 is also exhausted (an arrow V), in addition to the film forming chamber 11.

When the inside of the sheath 40 is decompressed and exhausted, the gas supply pipe 20 is moved down and is inserted into the resin container P housed in the film forming chamber 11. The exhaust by the exhaust pump 19 is continued in this state also at this time until the inside of the film forming chamber 11 reaches the desired degree of vacuum. The degree of vacuum at this time is about 10⁻¹ Torr to about 10⁻⁵ Torr.

Note that the exhaust inside the decompression chamber 43 of the sheath 40 may be performed in the bottle feeding step or the vacuum chamber closing step prior to the evacuation step. The degree of vacuum at this time is about 10⁻¹ Torr to about 10⁻⁵ Torr as with the degree of vacuum in the film forming chamber 11 described above.

### [Film Forming Step (FIG. 4C and Sill in FIG. 7)]

When the degree of vacuum of the film forming chamber 11 reaches the desired degree of vacuum, the power is supplied from the power supply 36 to cause the heater 30 to generate heat. On the other hand, the medium gas G is blown, from the raw material tank 27, into the resin container P housed in the film forming chamber 11, through the gas supply pipe 20. When the blown medium gas G comes into contact with the heater 30, the medium gas G is decomposed to generate chemical species, and the chemical species reach the inner surface of the resin container P to form the barrier film.

The film forming device 100 makes a transition from the standby time or the standby state to the film formation or the film forming state when the power is supplied to the heater 30.

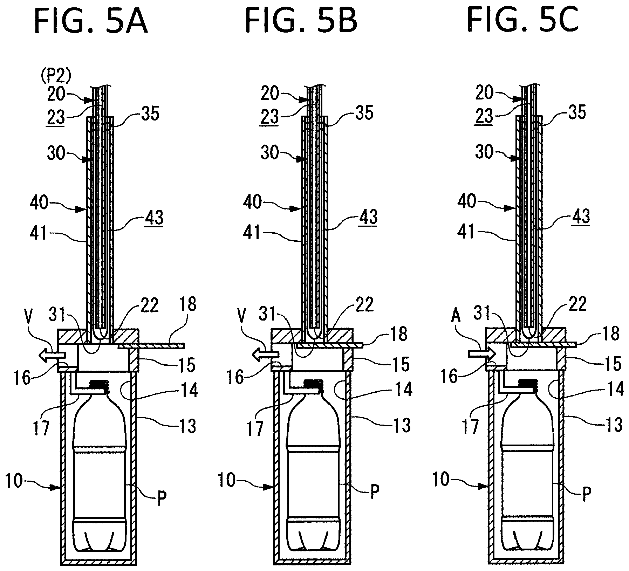

### [Gas Supply Pipe Retracting Step (FIG. 5A and S113 in FIG. 7)]

When a predetermined amount of the medium gas G has been supplied, the power supply to the heater 30 is stopped and the supply of the medium gas G is stopped, and the gas supply pipe 20 is then moved up to the retracted position P2. The operation of the exhaust pump 19 is continued.

The film forming device 100 makes a transition from the film formation or the film forming state to the standby time or the standby state when the power supply to the heater 30 is stopped.

### [Shield Valve Closing Step (FIG. 5B and S115 in FIG. 7)]

When the retraction of the gas supply pipe 20 is completed, the shield valve 18 is closed. Since the ceramic member 35 and the inner wall surface of the sheath 40 are sealed with each other, the decompression chamber 43 of the sheath 40 becomes a closed space except for the exhaust pipe 45. The space is a nearly vacuum state because being exhausted until the shield valve 18 is closed. To continue the vacuum state, the exhaust pump 47 is operated.

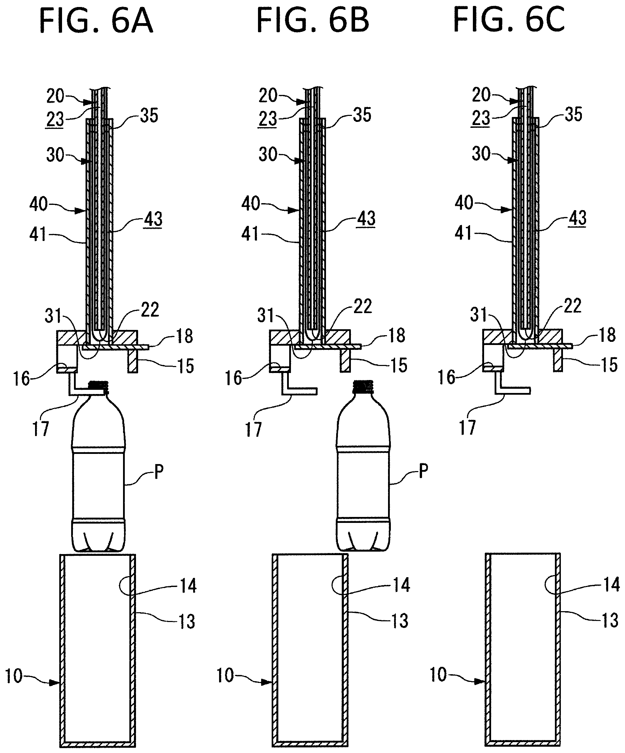

### [Chamber Opening to Atmosphere to Chamber Releasing (FIG. 5C, FIG. 6A, and S117 and S119 in FIG. 7)]

When the shield valve 18 is closed, the film forming chamber 11 of the vacuum chamber 10 is opened to the atmosphere (an arrow A in FIG. 5C), and the lower chamber 13 is then moved down to the retracted position. The exhaust pump 47 is continuously operated.

### [Bottle Discharging to Idling (FIGs. 6B and 6C, and S121 in FIG. 7)]

The resin container P in which the barrier film has been formed is transferred toward the downstream step through an appropriate conveying means, and the film forming device 100 stands by until the resin container P to be treated subsequently is transferred.

### [Operation and Effect]

Next, the film forming device 100 achieves the following effects because the gas supply pipe 20 is housed in the decompression chamber 43 of the sheath 40 and the decompression chamber 43 is maintained in the vacuum state in the standby time during which the film formation is not performed.

First, it is possible to reduce a time necessary for evacuation of the film forming chamber 11 performed prior to the film formation. In other words, it is necessary to discharge the gas component contained in the gas supply pipe 20 that is inserted into the resin container P housed in the film forming chamber 11, in the evacuation. A long time, however, is necessary to remove the gas component from the gas supply pipe 20 because the gas flow path 23 of the gas supply pipe 20 is narrow. In contrast, since the gas flow path 23 is maintained in the vacuum state in the standby time, it requires little or the minimum amount of time to discharge the gas component from the gas flow path 23. Therefore, the present embodiment makes it possible to reduce the time necessary for formation of the barrier film.

Next, the film forming device 100 makes it possible to prevent the gas flow path 23 of the gas supply pipe 20 from being blocked.

More specifically, when the vacuum chamber 10 is opened to the atmosphere after the barrier film is formed, particles as minute peeled pieces occur from a surface of the component that is deposited inside the gas supply pipe 20 and the vacuum chamber 10 in the film formation and is equivalent to the component of the barrier film, and the particles may enter and block the gas flow path 23. In addition, in a case where the medium gas G may react with oxygen and moisture in the air to generate a compound, the compound may block the gas flow path 23 as with the above-described particles.

In the film forming device 100, however, the gas flow path 23 is evacuated in the standby time, the particles and the compound do not enter the gas flow path 23.

As mentioned above, the film forming device 100 makes it possible to maintain the correct state of the gas supply pipe 20 necessary for the film forming of the barrier film. Therefore, according to the film forming device 100, frequency of maintenance with respect to the blocking of the gas supply pipe 20 is decreased, and continuous operation for a long period is ensured.

Next, the film forming device 100 makes it possible to prevent the heater 30 from being damaged by reaction with nitrogen, oxygen, and the like.

The temperature of the heater 30 reaches high temperature exceeding 1000°C during the formation of the barrier film. Therefore, if energization is stopped after the film formation is completed, the heater 30 maintains the high temperature disadvantageously. Accordingly, if the heater 30 in the high temperature state comes into contact with the air, the vicinity of the surface of the heater 30 reacts mainly with nitrogen and oxygen in the air, and the heater 30 may accordingly be damaged with losing the original function.

In the film forming device 100, however, since the heater 30 is housed in the decompression chamber 43 that is evacuated together with the gas supply pipe 20 after the film formation, it is possible to suppress reaction with nitrogen, oxygen, and the like, and to maintain the heater 30 in the correct state. Accordingly, the film forming device 100 makes it possible to reduce the frequency of maintenance of the heater 30, and to ensure continuous operation for a long period.

In addition, in the film forming device 100, the sheath 40 including the decompression chamber 43 is provided as a means of decompressing the gas flow path 23 of the gas supply pipe 20, and the decompression chamber 43 is decompressed through the gas flow path 23 that communicates with the decompression chamber 43. Further, since the sheath 40 is fixed in position, it is possible to simplify the mechanism for decompression. In addition, since the sheath 40 functions as the guide for up-and-down movement of the gas supply pipe 20, it is unnecessary to additionally provide a mechanism that guides the gas supply pipe 20. Furthermore, since it is sufficient for the decompression chamber 43 to have a minimum space necessary for up-and-down movement of the gas supply pipe 20, it is possible to reduce the time necessary for decompression of the gas flow path 23. Moreover, since it is sufficient for the sheath 40 to have a minimum space enough to house the gas supply pipe 20, the decompression state of the decompression chamber 43 in the sheath 40 is easily maintained.

Further, in the film forming device 100, the sheath 40 is attached to the upper chamber 15 of the vacuum chamber 10, and the decompression chamber 43 communicates with the film forming chamber 11. As mentioned above, since the sheath 40 in which the gas supply pipe 20 is advancebly and retreatably housed is directly connected to the vacuum chamber 10 without piping, it is possible to simplify and downsize the configuration of the film forming device 100.

### [Second Embodiment]

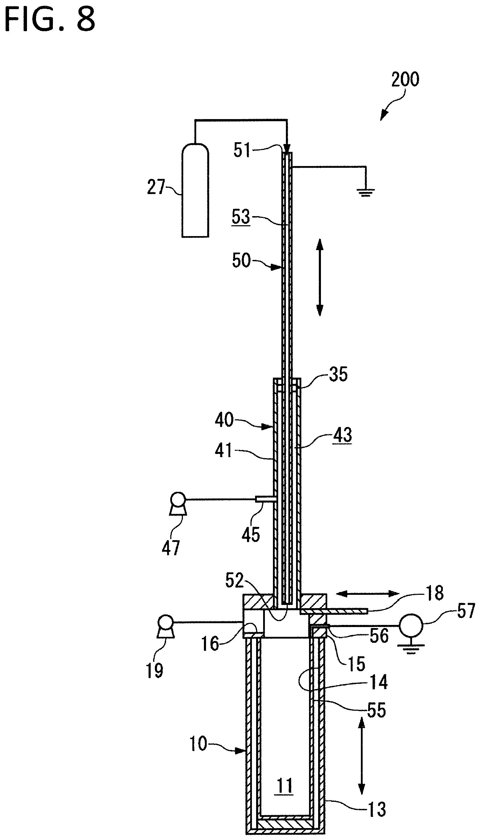

In the above-described embodiment, the example in which the present invention is applied to the Cat-CVD method has been described; however, the present invention is applicable to formation of the barrier film by the other CVD method, for example, the plasma CVD method. The film forming device 200 that realizes formation of the barrier film is described with reference to FIG. 8. Note that, in FIG. 8, components similar to the components of the film forming device 100 are denoted by the same reference numerals of FIG. 1A, FIG. 1B and FIG. 2, and the film forming device 200 is described below while focusing on differences with the film forming device 100.

As illustrated in FIG. 8, the film forming device 200 includes: an external electrode 55 that has a size surrounding an outer periphery of the resin container P; an internal electrode 50 in which a gas flow path 53 blowing out the medium gas G is provided between a connection end 51 and a discharge hole 52; a high-frequency power supply 57 that is electrically connected to the external electrode 55; and the vacuum chamber 10 that covers the external electrode 55. Note that a spacer made of dielectric substance may be interposed between the external electrode 55 and at least one of a spout, a shoulder part, and other parts of the resin container P, or an insulating member may be interposed between the external electrode 55 and the upper chamber 15 when the resin container P is inserted.

As with the gas supply pipe 20, the internal electrode 50 is movable up and down between the film forming position P1 at which the internal electrode 50 is inserted into the resin container P housed in the external electrode 55 and the retracted position P2 at which the film formation is not performed. As with the gas supply pipe 20, the internal electrode 50 is also moved up and down while being partially housed in the decompression chamber 43 of the sheath 40.

Next, outline of a method of forming a carbon film on the inner peripheral surface of the resin container P by the film forming device 200 is described.

First, the resin container P is inserted into the external electrode 55, and gas inside the vacuum chamber 10 is discharged through the exhaust passage 16. After the degree of the vacuum reaches the specified degree, the medium gas G is supplied to the internal electrode 50 while the exhaust is continued, and the medium gas G is blown into the resin container P through the gas flow path 53 of the internal electrode 50. Note that examples of the medium gas G may include aliphatic hydrocarbons, aromatic hydrocarbons, oxygen-containing hydrocarbons, and nitrogen-containing hydrocarbons, such as benzene, toluene, xylene, and cyclohexane. The pressure inside the resin container P is set on the basis of balance between the gas supply amount and the exhaust amount. Thereafter, high-frequency power is applied from the high-frequency power supply 57 to the external electrode 55 through an input terminal 56.

Plasma is generated between the external electrode 55 and the internal electrode 50 by application of the high-frequency power to the external electrode 55. At this time, the resin container P is housed inside the external electrode 55 with substantially no gap, and the plasma is generated inside the resin container P. The medium gas G is dissociated or further ionized by the plasma, and film forming species for formation of a carbon film are accordingly generated. The film forming species are deposited on the inner peripheral surface of the resin container P to form the carbon film. After the carbon film is formed up to a predetermined film thickness, application of the high-frequency power is stopped and the supply of the medium gas G is stopped. Thereafter, the remaining gas is discharged, and nitrogen, rare gas, air, or the like is then supplied to the vacuum chamber 10 (the external electrode 55) to return the pressure inside the space to the atmospheric pressure. Thereafter, the resin container P is detached from the external electrode 55.

In the film forming device 200, the gas supply pipe 20 is housed in the decompression chamber 43 of the sheath 40 and the decompression chamber 43 is maintained in the vacuum state in the standby time during which the film formation is not performed, as with the film forming device 100. Therefore, the film forming device 200 makes it possible to achieve the effects similar to the effects of the film forming device 100 according to the first embodiment.

### [Third Embodiment] (Claim 7 and Claim 15)

When the present invention is applied to the Cat-CVD method, prevention of deterioration of the heater 30 is important. More specifically, in the film formation, the heater 30 is heated to the temperature close to 2000°C. Therefore, if the air (including oxygen, nitrogen, and moisture) even in a small amount remains inside the vacuum chamber 10, the heater 30 is oxidized or nitrided and may not be usable thereafter. Accordingly, to prevent deterioration of the heater 30 due to oxidization or the like, a first method and a second method described below are proposed as a third embodiment.

### [First Method] (Claim 7 and Claim 15)

In the first method, the inside of the sheath 40 is in advance filled with gas stable to the film formation, in the standby time prior to the film forming step. When the pressure of the decompression chamber 43 inside the sheath 40 at this time is denoted by P₄₀, and the pressure inside the vacuum chamber 10 is denoted by P₁₀, the pressure P₄₀ is set larger than the pressure P₁₀ (P₄₀> P₁₀). Incidentally, the pressure P₄₀ of the decompression chamber 43 is still lower than the atmospheric pressure.

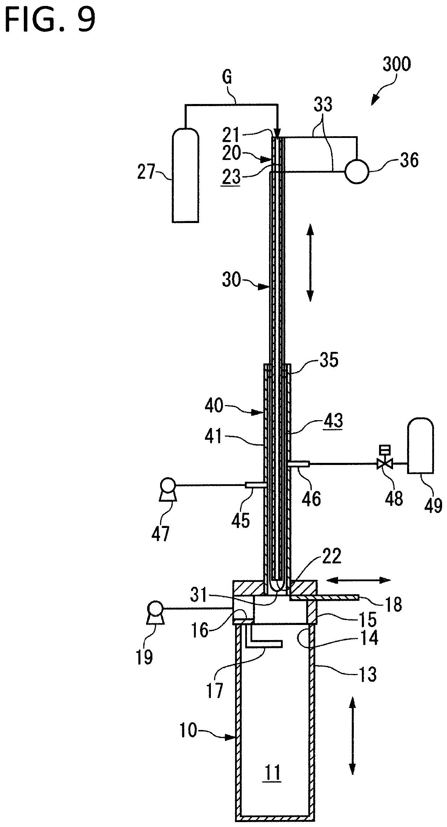

As illustrated in FIG. 9, in a film forming device 300, an air supply pipe 46 that makes the decompression chamber 43 to communicate with the outside of the sheath body 41 is provided in the sheath body 41, and a gas tank 49 is connected to the air supply pipe 46 through a switch valve 48. A first gas supply source is configured of the air supply pipe 46, the switch valve 48, and the gas tank 49. The gas stable to the film formation is stored in the gas tank 49. It is possible to supply the gas stable to the film formation by opening the switch valve 48, and to store the gas stable to the film formation, in the decompression chamber 43 inside the sheath 40 including the inside of the gas flow path 23. Thereafter, it is possible to introduce the stable gas into the film forming chamber 11. The gas stable to the film formation used herein indicates gas that does not cause reaction other than reaction relating the film formation by the medium gas G in the film formation, and such gas typically includes the medium gas G. Such gas includes rare gas, in addition to the medium gas G. Note that the rare gas includes helium (He), neon (Ne), argon (Ar), krypton (Kr), xenon (Xe), and radon (Rn), among elements belonging to the group 18 in the periodic table.

In the first method, the basic procedure of forming the barrier film with use of the film forming device 300 is similar to the procedure of the first embodiment, and differences with the first embodiment are mainly described below.

In the first method, the exhaust pump 47 is operated to decompress and exhaust the decompression chamber 43 of the sheath 40 before the film forming step (FIG. 4C and Sill in FIG. 7). The switch valve 48 is opened to introduce the gas stable to the film formation, into the decompression chamber 43 after the operation of the exhaust pump 47 is stopped. As described above, the gas stable to the film formation is introduced in such a manner that the pressure P₄₀ of the decompression chamber 43 becomes larger than the pressure P₁₀ of the inside of the vacuum chamber 10.

The decompression and exhaust of the decompression chamber 43 and introduction of the gas stable to the film formation into the decompression chamber 43 may be performed in any of the bottle feeding step (FIG. 3A and S101 in FIG. 7), the vacuum chamber closing step (FIG. 3B and S103 in FIG. 7), and the evacuation step (FIG. 3C, FIG. 4A, FIG. 4B, and S105 to S109 in FIG. 7).

When the state of the pressure P₄₀>the pressure P₁₀ is established, the closed shield valve 18 is opened (FIG. 4A). The operation belongs to the evacuation step in the first embodiment, and the exhaust pump 19 is still operated as with the first embodiment. As a result, the gas stable to the film formation is introduced from the decompression chamber 43 of the sheath 40 into the film forming chamber 11 of the vacuum chamber 10 while the film forming chamber 11 is decompressed and exhausted. When the exhaust by the exhaust pump 19 is continued until the degree of vacuum inside the film forming chamber 11 reaches the desired degree of vacuum, the air remaining in the film forming chamber 11 is purged from the film forming chamber 11 by the introduced gas stable to the film formation.

Thereafter, the film forming step, the gas supply pipe retracting step, the shield valve closing step, the chamber opening to the air to the chamber releasing, and the bottle discharging to the idling described in the first embodiment are sequentially performed.

### [Second Method] (Claim 8 and Claim 15)

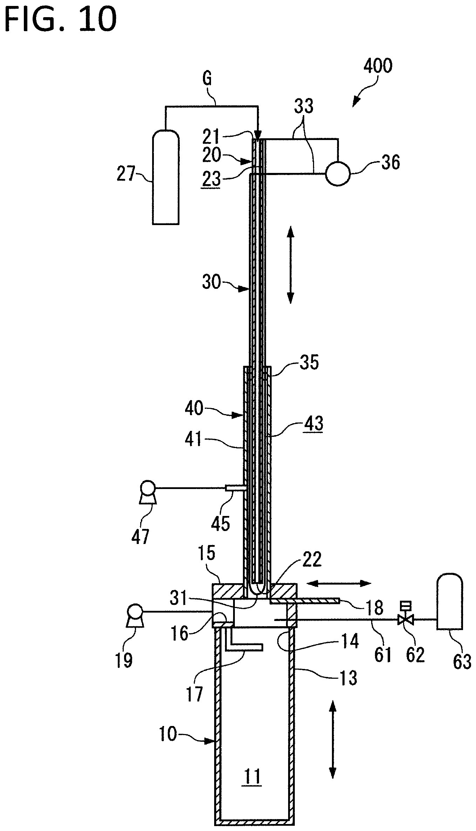

Next, the second method using a film forming device 400 illustrated in FIG. 10 is described.

The second method is the same as the first method in that the air remaining inside the film forming chamber 11 is purged by the gas stable to the film formation in the standby time prior to the film forming step; however, the second method includes a means of supplying the gas stable to the film formation, into the film forming chamber 11. In other words, as illustrated in FIG. 10, the film forming device 400 includes, in the vacuum chamber 10, an air supply pipe 61 that causes the inside of the film forming chamber 11 to communicate with the outside of the film forming chamber 11. A gas tank 63 is connected to the air supply pipe 61 through a switch valve 62. A second gas supply source is configured of the air supply pipe 61, the switch valve 62, and the gas tank 63. The gas stable to the film formation is stored in the gas tank 63 as with the gas tank 49. Opening the switch valve 62 makes it possible to supply the gas stable to the film formation, and to fill the film forming chamber 11 with the gas stable to the film formation. Note that a front end of the air supply pipe 61 may be folded toward the inside of the resin container P.

In the second method, the basic procedure of forming the barrier film with use of the film forming device 400 is similar to the procedure in the first embodiment. In the following, differences with the first embodiment are mainly descried.

In the second method, the procedure similar to the procedure in the first embodiment is performed from the bottle feeding step to the evacuation step; however the switch valve 62 is opened to introduce, into the film forming chamber 11, the gas stable to the film formation in the middle of the evacuation step, namely, during operation of the exhaust pump 19.

When a necessary amount of the gas stable to the film formation has been introduced, the closed shield valve 18 is opened. When the exhaust by the exhaust pump 19 is continued until the degree of vacuum inside the film forming chamber 11 reaches the desired degree of vacuum, the air remaining in the film forming chamber 11 is purged from the film forming chamber 11 by the introduced gas stable to the film formation.

Thereafter, the film forming step, the gas supply pipe retracting step, the shield valve closing step, the step of chamber opening to air to chamber releasing, and the step of bottle discharging to idling described in the first embodiment are sequentially performed.

As described above, introducing, into the film forming chamber 11, the gas stable to the film formation and evacuating the film forming chamber 11 to purge the air remaining the film forming chamber 11 make it possible to prevent the heater 30 from being oxidized or nitrided during the film forming step. In contrast, if the gas stable to the film formation remains in the film forming chamber 11, the heater 30 is not deteriorated.

As mentioned above, although some preferred embodiments of the present invention have been described, the configurations described in the above-described embodiments may be selected or may be appropriately modified without departing from the scope of the present invention.

The sheath 40 is provided to decompress, preferably evacuate the gas flow path 23 of the gas supply pipe 20 in the present embodiment; however, the specific means for decompression and evacuation is optional as long as the means is retracted from the film forming chamber 11 and the gas flow path 23 is maintained in the decompression state in the standby time during which the formation of the gas barrier film is not performed. For example, an exhaust pump is connected to the connection end 21 of the gas supply pipe 20 while the discharge hole 22 of the gas supply pipe 20 is closed, which allows for decompression and exhaust without the sheath 40.

### (Claim 6)

In addition, in the above-described first embodiment, the supply of the medium gas G to the gas supply pipe 20 is also stopped in the gas supply pipe retracting step when the supply of the power to the heater 30 is stopped. The present invention, however, may continue the supply of the medium gas G in the standby time after the film formation is completed. The supply of the medium gas G is performed for a predetermined period until the shield valve 18 is closed. As a result, the medium gas G is supplied to the gas supply pipe 20 and the film forming chamber 11 through the gas supply pipe 20, which makes it possible to cool the heater 30 while removing the remaining air inside the film forming chamber 11 and the decompression chamber 43.

Since the heater 30 is in the high temperature range even after the supply of the power to the heater 30 is stopped, cooling the heater 30 by the medium gas G makes it possible to prevent reaction with oxygen, water vapor, and the like that may remain in the film forming chamber 11.

After the shield valve 18 is closed to stop the supply of the medium gas G, the exhaust pump 47 may be preferably operated to decompress and exhaust the decompression chamber 43.

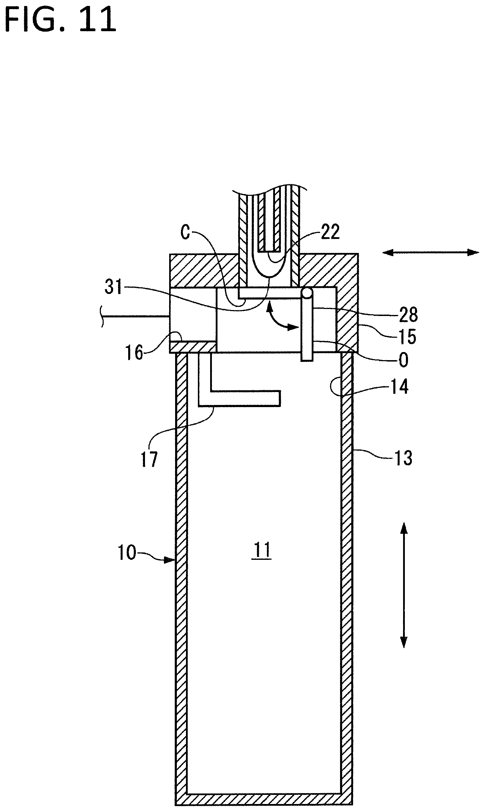

Further, the example in which the sliding shield valve 18 is used to partition the film forming chamber 11 and the decompression chamber 43 has been described in the above-described embodiment; however, a shield valve 28 that swings between a closed position C and an open position O may be used, as illustrated in FIG. 11.

The shield valve 28 performs open and close operation only inside the vacuum chamber 10, which makes it possible to downsize the film forming device as compared with the case where the shield valve 18 projecting to the outside of the vacuum chamber 10 is used.

Moreover, the sheath 40 that has a minimum space necessary for up-and-down movement of the gas supply pipe 20 has been described in the above-described embodiment; however, the preset invention is not limited thereto, and a housing having an extra space for the gas supply pipe 20 may be used. The decompression chamber 43, however, may preferably have a capacity as small as possible because the decompression chamber 43 with the capacity larger than necessary requires a long time for decompression and exhaust. The decompression chamber 43 may preferably have a capacity equal to or smaller than the capacity of the film forming chamber 11, depending on the size of the resin container P in which the film is to be formed.

Further, for example, the resin configuring the resin container P used in the present invention is optional. For example, a polyethylene terephthalate (PET) resin, a polybutylene terephthalate resin, a polyethylene naphthalate resin, a polyethylene resin, a polypropylene (PP) resin, and a cycloolefin copolymer (COC, cyclic olefin copolymer) resin may be used.

In addition, the container in the present invention is usable for optional application, and is widely applicable to a container that houses beverages such as water, a tea beverage, a refreshing beverage, a carbonated beverage, and a fruit juice beverage, liquid, a viscous body, or powdered or solid foods.

In addition, a material of the barrier film is also optional, and a material that may form a film by the CVD method using the medium gas G, typically, various materials such as a carbon film, a silica film, and an alumina film are adoptable.

A specific example of the carbon film includes an amorphous carbon film that has an amorphous structure in which a diamond component (a bond of carbon atoms is SP³ bond), a graphite component (a bond of carbon atoms is SP² bond), and a polymer component (a bond of carbon atoms is SP¹ bond) are mixed. The amorphous carbon film is changed in hardness due to variation of an existence ratio of the bond component of each carbon atom, and contains a hard carbon film and a soft carbon film. In addition, the amorphous carbon film includes a hydrogenated amorphous carbon containing hydrogen. Further the hard carbon film includes an amorphous DLC film that mainly contains SP³ bond.

In addition, examples of the other barrier film may include a SiOx film, an AlOx film, a hydrogen-containing SiNx film, a hydrogen-containing DLC film, a hydrogen-containing SiOx film, and a hydrogen-containing SiCxNy film.

### Reference Signs List

- 100, 200, 300, 400: Film forming device
- 10: Vacuum chamber
- 11: Film forming chamber
- 13: Lower chamber
- 14: Gateway
- 15: Upper chamber
- 16: Exhaust passage
- 17: Gripper
- 18: Shield valve
- 19: Exhaust pump
- 20: Gas supply pipe
- 21: Connection end
- 22: Discharge hole
- 23: Gas flow path
- 25: Main region
- 26: Sub-region
- 27: Raw material tank
- 28: Shield valve
- 30: Heater
- 33: Lead wire
- 35: Ceramic member
- 36: Power supply
- 40: Sheath
- 41: Sheath body
- 42: Opening
- 43: Decompression chamber
- 45: Exhaust pipe
- 46: Air supply pipe
- 47: Exhaust pump
- 48: Switch valve
- 49: Gas tank
- 50: Internal electrode
- 51: Connection end
- 52: Discharge hole
- 53: Gas flow path
- 55: External electrode
- 56: Input terminal
- 57: High-frequency power supply
- 61: Air supply pipe
- 62: Switch valve
- 63: Gas tank
- P: Resin container

## Claims

1. A film forming device (100, 200, 300, 400), comprising:
a chamber (10) that includes a film forming chamber (11) housing a container (P) in which a gas barrier film is to be formed, the film forming chamber (11) being adapted to be brought into a vacuum state in formation of the gas barrier film; and
a gas supply pipe (20) that includes a gas flow path (23) and is adapted to be moved up and down along an axial direction, the gas flow path (23) conducting, into the container (P), medium gas (G) used for the formation of the gas barrier film, wherein
the gas supply pipe (20) is adapted to be inserted into the container (P) housed in the film forming chamber (11), and adapted to supply the medium gas (G) through the gas flow path (23), in the formation of the gas barrier film,
wherein the gas supply pipe (20) is adapted to be retracted from the film forming chamber (11) and the gas flow path (23) is adapted to be maintained in a decompression state in a standby time during which the formation of the gas barrier film is not performed;
**characterized in that** the film forming device (100, 200, 300, 400) further comprises a decompression chamber (43) that communicates with the gas flow path (23) of the gas supply pipe (20) in the standby time, wherein
the gas flow path (23) is maintained in the decompression state by decompression of the decompression chamber (43);
wherein the film forming device (100, 200, 300, 400) further comprises a housing (40) that stands up on and is supported by an upper chamber (15) of the chamber (10) along a vertical direction; a lower part of the sheath body (41) is an opening (42) that penetrates through the upper chamber (15); the housing (40) comprising a sheath body (41), as well as the decompression chamber (43) provided inside the sheath body (41); the gas supply pipe (20) is moved up and down inside the decompression chamber (43), thereby being inserted into and pulled out from the film forming chamber (11), wherein
the gas supply pipe (20) is adapted to be inserted into and pulled out from the container (P) through the chamber (10) ;
wherein the film forming device (100, 200, 300, 400) further comprises a heater (30) that is supported by the gas supply pipe (20), wherein
the heater (30) is adapted to be inserted into and pulled out from the container (P), following the insertion and pullout of the gas supply pipe (20).

2. The film forming device (100, 200, 300, 400) according to claim 1, further comprising a shield valve (18) that blocks communication between the film forming chamber (11) and the decompression chamber (43) when the gas supply pipe (20) is retracted from the film forming chamber (11).

3. The film forming device (100, 200, 300, 400) according to claim 1 or 2, further comprising a first gas supply source that is adapted to supply, to the decompression chamber (43), gas stable to the formation of the gas barrier film, wherein
the stable gas is for being introduced from the decompression chamber (43) into the film forming chamber (11) after the stable gas is supplied from the first gas supply source to the decompression chamber (43) and stored in the decompression chamber (43), in the standby time prior to the formation of the gas barrier film.

4. The film forming device (100, 200, 300, 400) according to claim 1 or 2, further comprising a second gas supply source that is adapted to supply, to the film forming chamber (11), gas stable to the formation of the gas barrier film, wherein
the second gas supply source is adapted to supply the stable gas to the film forming chamber (11) in the standby time prior to the formation of the gas barrier film.

5. The film forming device (100, 200, 300, 400) according to claim 1 or 2, further comprising:
an external electrode (55) that is disposed in the film forming chamber (11) and houses the container (P); and
an internal electrode (50) that is adapted to be inserted into and pulled out from the container (P) housed in the external electrode (55), and to conduct the medium gas (G) into the container (P), wherein
the internal electrode (50) constitutes the gas supply pipe (20).

6. A film forming method, comprising:
housing a container (P) in which a gas barrier film is to be formed, in a film forming chamber (11) in a vacuum state; and
conducting medium gas (G) used for formation of the gas barrier film, into the container (P) to form the gas barrier film, wherein the film forming method includes
a film forming state in which a gas supply pipe (20) is inserted into the container (P) housed in the film forming chamber (11) and the medium gas (G) is supplied to the container (P) through a gas flow path (23), the gas supply pipe (20) including the gas flow path (23) that conducts the medium gas (G) into the container (P), and the gas supply pipe (20) being moved up and down along an axial direction, and
a standby state in which the gas supply pipe (20) continues to supply the medium gas (G) to the film forming chamber (11) for a predetermined time period after the formation of the gas barrier film is completed, and then the gas supply pipe (20) is retracted from the film forming chamber (11) and the gas flow path (23) is maintained in a decompression state;
wherein the gas flow path (23) is maintained in the decompression state by decompression of a decompression chamber (43) in the standby state, the decompression chamber (43) communicating with the gas flow path (23) of the gas supply pipe (20);
wherein a housing (40) including the decompression chamber (43) in which the gas supply pipe (20) is moved up and down, is further provided, and
the gas supply pipe (20) is inserted into and pulled out from the container (P) through a chamber (10) that surrounds the film forming chamber (11);
wherein a heater (30) supported by the gas supply pipe (20) is further provided, and
the heater (30) is inserted into and pulled out from the container (P), following the insertion and pullout of the gas supply pipe (20).

7. The film forming method according to claim 6, wherein communication between the film forming chamber (11) and the decompression chamber (43) is blocked when the gas supply pipe (20) is retracted from the film forming chamber (11).

8. The film forming method according to claim 6 or 7, wherein gas stable to the formation of the gas barrier film is supplied to the film forming chamber (11) in a standby time prior to the formation of the gas barrier film.

9. The film forming method according to claims 6 to 8, wherein
an external electrode (55) and an internal electrode (50) are further provided, the external electrode (55) being disposed in the film forming chamber (11) and housing the container (P), and the internal electrode (50) being inserted into and pulled out from the container (P) housed in the external electrode (55) and conducting the medium gas (G) into the container (P), and
the internal electrode (50) constitutes the gas supply pipe (20).

## Patentansprüche

1. Filmbildungsvorrichtung (100, 200, 300, 400), umfassend:
eine Kammer (10), die eine Filmbildungskammer (11) einschließt, die einen Behälter (P) aufnimmt, in dem ein Gassperrfilm gebildet werden soll, wobei die Filmbildungskammer (11) dazu geeignet ist, bei der Bildung des Gassperrfilms in einen Vakuumzustand gebracht zu werden; und
ein Gaszufuhrrohr (20), das einen Gasströmungsweg (23) einschließt und dazu geeignet ist, entlang einer axialen Richtung nach oben und unten bewegt zu werden, wobei der Gasströmungsweg (23) ein Mediengas (G), das für die Bildung des Gassperrfilms verwendet wird, in den Behälter (P) leitet, wobei
das Gaszufuhrrohr (20) dazu geeignet ist, in den Behälter (P), der in der Filmbildungskammer (11) aufgenommen ist, eingeführt zu werden, und dazu geeignet ist, das Mediengas (G) bei der Bildung des Gassperrfilms durch den Gasströmungsweg (23) zuzuführen,
wobei das Gaszufuhrrohr (20) dazu geeignet ist, aus der Filmbildungskammer (11) herausgezogen zu werden, und der Gasströmungsweg (23) dazu geeignet ist, in einer Standby-Zeit, während der die Bildung des Gassperrfilms nicht ausgeführt wird, in einem Dekompressionszustand gehalten zu werden;
**dadurch gekennzeichnet, dass** die Filmbildungsvorrichtung (100, 200, 300, 400) weiter eine Dekompressionskammer (43) umfasst, die in der Standby-Zeit mit dem Gasströmungsweg (23) des Gaszufuhrrohrs (20) kommuniziert, wobei
der Gasströmungsweg (23) durch Dekomprimieren der Dekompressionskammer (43) in dem Dekompressionszustand gehalten wird;
wobei die Filmbildungsvorrichtung (100, 200, 300, 400) weiter ein Gehäuse (40) umfasst, das auf einer oberen Kammer (15) der Kammer (10) entlang einer vertikalen Richtung aufragt und von dieser getragen wird; ein unterer Teil des Hülsenkörpers (41) eine Öffnung (42) ist, die die obere Kammer (15) durchdringt; das Gehäuse (40) einen Hülsenkörper (41) sowie die innerhalb des Hülsenkörpers (41) vorgesehene Dekompressionskammer (43) umfasst; das Gaszufuhrrohr (20) innerhalb der Dekompressionskammer (43) nach oben und unten bewegt wird, wodurch es in die Filmbildungskammer (11) eingeführt und aus dieser herausgezogen wird, wobei
das Gaszufuhrrohr (20) dazu geeignet ist, durch die Kammer (10) in den Behälter (P) eingeführt und aus diesem herausgezogen zu werden;
wobei die Filmbildungsvorrichtung (100, 200, 300, 400) weiter eine Heizung (30) umfasst, die von dem Gaszufuhrrohr (20) getragen wird, wobei
die Heizung (30) dazu geeignet ist, nach dem Einführen und Herausziehen des Gaszufuhrrohrs (20) in den Behälter (P) eingeführt und aus diesem herausgezogen zu werden.

2. Filmbildungsvorrichtung (100, 200, 300, 400) nach Anspruch 1, weiter umfassend ein Abschirmventil (18), das die Kommunikation zwischen der Filmbildungskammer (11) und der Dekompressionskammer (43) blockiert, wenn das Gaszufuhrrohr (20) aus der Filmbildungskammer (11) herausgezogen ist.

3. Filmbildungsvorrichtung (100, 200, 300, 400) nach Anspruch 1 oder 2, weiter umfassend eine erste Gaszufuhrquelle, die dazu geeignet ist, der Dekompressionskammer (43) Gas zuzuführen, das für die Bildung des Gassperrfilms stabil ist, wobei
das stabile Gas zum Einführen von der Dekompressionskammer (43) in die Filmbildungskammer (11) gedacht ist, nachdem das stabile Gas von der ersten Gaszufuhrquelle zur Dekompressionskammer (43) zugeführt, und in der Standby-Zeit vor der Bildung des Gassperrfilms in der Dekompressionskammer (43) gelagert wurde.

4. Filmbildungsvorrichtung (100, 200, 300, 400) nach Anspruch 1 oder 2, weiter umfassend eine zweite Gaszufuhrquelle, die dazu geeignet ist, der Filmbildungskammer (11) Gas zuzuführen, das für die Bildung des Gassperrfilms stabil ist, wobei
die zweite Gaszufuhrquelle dazu geeignet ist, in der Standby-Zeit vor der Bildung des Gassperrfilms das stabile Gas der Filmbildungskammer (11) zuzuführen.

5. Filmbildungsvorrichtung (100, 200, 300, 400) nach Anspruch 1 oder 2, weiter umfassend:
eine externe Elektrode (55), die in der Filmbildungskammer (11) angeordnet ist und den Behälter (P) aufnimmt; und
eine interne Elektrode (50), die dazu geeignet ist, in den Behälter (P), der in der externen Elektrode (55) aufgenommen ist, eingeführt und aus diesem herausgezogen zu werden und das Mediengas (G) in den Behälter (P) zu leiten, wobei
die interne Elektrode (50) das Gaszufuhrrohr (20) darstellt.

6. Filmbildungsverfahren, umfassend:
Aufnehmen eines Behälters (P), in dem ein Gassperrfilm gebildet werden soll, in einer Filmbildungskammer (11) in einem Vakuumzustand; und
Leiten von Mediengas (G), das zur Bildung des Gassperrfilms verwendet wird, in den Behälter (P), um den Gassperrfilm zu bilden, wobei das Filmbildungsverfahren einschließt
einen Filmbildungszustand, in dem ein Gaszufuhrrohr (20) in den in der Filmbildungskammer (11) aufgenommenen Behälter (P) eingeführt ist und das Mediengas (G) dem Behälter (P) durch einen Gasströmungsweg (23) zugeführt wird, wobei das Gaszufuhrrohr (20) den Gasströmungsweg (23) einschließt, der das Mediengas (G) in den Behälter (P) leitet, und das Gaszufuhrrohr (20) entlang einer axialen Richtung nach oben und unten bewegt wird, und
einen Standby-Zustand, in dem das Gaszufuhrrohr (20) der Filmbildungskammer (11) für einen vorbestimmten Zeitraum, nachdem die Bildung des Gassperrfilms abgeschlossen ist, weiterhin das Mediengas (G) zuführt und dann das Gaszufuhrrohr (20) aus der Filmbildungskammer (11) herausgezogen wird und der Gasströmungsweg (23) in einem Dekompressionszustand gehalten wird;
wobei der Gasströmungsweg (23) durch Dekomprimieren einer Dekompressionskammer (43) im Dekompressionszustand im Standby-Zustand gehalten wird, wobei die Dekompressionskammer (43) mit dem Gasströmungsweg (23) des Gaszufuhrrohrs (20) kommuniziert;
wobei weiter ein Gehäuse (40), das die Dekompressionskammer (43), in der das Gaszufuhrrohr (20) nach oben und nach unten bewegt wird, einschließt, vorgesehen ist, und
das Gaszufuhrrohr (20) durch eine Kammer (10), die die Filmbildungskammer (11) umgibt, in den Behälter (P) eingeführt und aus diesem herausgezogen wird;
wobei weiter eine Heizung (30), die von dem Gaszufuhrrohr (20) getragen wird, vorgesehen ist, und
die Heizung (30) nach dem Einführen und Herausziehen des Gaszufuhrrohrs (20) in den Behälter (P) eingeführt und aus diesem herausgezogen wird.

7. Filmbildungsverfahren nach Anspruch 6, wobei die Kommunikation zwischen der Filmbildungskammer (11) und der Dekompressionskammer (43) blockiert wird, wenn das Gaszufuhrrohr (20) aus der Filmbildungskammer (11) herausgezogen wird.

8. Filmbildungsverfahren nach Anspruch 6 oder 7, wobei in einer Standby-Zeit vor der Bildung des Gassperrfilms der Filmbildungskammer (11) Gas, das für die Bildung des Gassperrfilms stabil ist, zugeführt wird.

9. Filmbildungsverfahren nach den Ansprüchen 6 bis 8, wobei
weiter eine externe Elektrode (55) und eine interne Elektrode (50) vorgesehen sind, wobei die externe Elektrode (55) in der Filmbildungskammer (11) angeordnet ist und den Behälter (P) aufnimmt und die interne Elektrode (50) in den Behälter (P), der in der externen Elektrode (55) aufgenommen ist, eingeführt, und aus diesem herausgezogen wird, und das Mediengas (G) in den Behälter (P) leitet, und
die interne Elektrode (50) das Gaszufuhrrohr (20) darstellt.

## Revendications

1. Dispositif de formation de film (100, 200, 300, 400) comprenant :
une chambre (10) qui inclut une chambre de formation de film (11) logeant un récipient (P) dans lequel un film barrière aux gaz doit être formé, la chambre de formation de film (11) étant adaptée pour être amenée dans un état de vide lors de la formation du film barrière aux gaz ; et
un tuyau d'alimentation en gaz (20) qui inclut un trajet d'écoulement de gaz (23) et est adapté pour être déplacé vers le haut et vers le bas le long d'une direction axiale, le trajet d'écoulement de gaz (23) conduisant, dans le récipient (P), un milieu gazeux (G) utilisé pour la formation du film barrière aux gaz, dans lequel
le tuyau d'alimentation en gaz (20) est adapté pour être inséré dans le récipient (P) logé dans la chambre de formation de film (11), et adapté pour alimenter le milieu gazeux (G) à travers le trajet d'écoulement de gaz (23), lors de la formation du film de barrière de gaz,
dans lequel le tuyau d'alimentation en gaz (20) est adapté pour être rétracté à partir de la chambre de formation de film (11) et le trajet d'écoulement de gaz (23) est adapté pour être maintenu dans un état de décompression pendant un temps de veille durant lequel la formation du film barrière aux gaz n'est pas effectuée ;
**caractérisé en ce que** le dispositif de formation de film (100, 200, 300, 400) comprend en outre une chambre de décompression (43) qui communique avec le trajet d'écoulement de gaz (23) du tuyau d'alimentation en gaz (20) pendant le temps de veille, dans lequel
le trajet d'écoulement de gaz (23) est maintenu dans l'état de décompression par décompression de la chambre de décompression (43) ;
dans lequel le dispositif de formation de film (100, 200, 300, 400) comprend en outre un logement (40) qui se dresse sur et est supporté par une chambre supérieure (15) de la chambre (10) le long d'une direction verticale ; une partie inférieure du corps de gaine (41) est une ouverture (42) qui pénètre à travers la chambre supérieure (15) ; le logement (40) comprenant un corps de gaine (41), ainsi que la chambre de décompression (43) disposée à l'intérieur du corps de gaine (41) ; le tuyau d'alimentation en gaz (20) est déplacé vers le haut et vers le bas à l'intérieur de la chambre de décompression (43), en étant ainsi inséré dans et retiré de la chambre de formation de film (11), dans lequel
le tuyau d'alimentation en gaz (20) est adapté pour être inséré dans le récipient (P) et retiré de celui-ci à travers la chambre (10) ;
dans lequel le dispositif de formation de film (100, 200, 300, 400) comprend en outre un dispositif de chauffage (30) qui est supporté par le tuyau d'alimentation en gaz (20), dans lequel
le dispositif de chauffage (30) est adapté pour être inséré dans le récipient (P) et retiré de celui-ci, après l'insertion et l'extraction du tuyau d'alimentation en gaz (20).

2. Dispositif de formation de film (100, 200, 300, 400) selon la revendication 1, comprenant en outre une soupape de protection (18) qui bloque une communication entre la chambre de formation de film (11) et la chambre de décompression (43) lorsque le tuyau d'alimentation en gaz (20) est rétracté à partir de la chambre de formation de film (11).

3. Dispositif de formation de film (100, 200, 300, 400) selon la revendication 1 ou 2, comprenant en outre une première source d'alimentation en gaz qui est adaptée pour alimenter, vers la chambre de décompression (43), un gaz stable pour la formation du film de barrière aux gaz, dans lequel
le gaz stable est destiné à être introduit à partir de la chambre de décompression (43) jusque dans la chambre de formation de film (11) après que le gaz stable ait été alimenté à partir de la première source d'alimentation en gaz vers la chambre de décompression (43) et stocké dans la chambre de décompression (43), pendant le temps de veille avant la formation du film barrière aux gaz.

4. Dispositif de formation de film (100, 200, 300, 400) selon la revendication 1 ou 2, comprenant en outre une seconde source d'alimentation en gaz qui est adaptée pour alimenter, vers la chambre de formation de film (11), un gaz stable pour la formation du film barrière aux gaz, dans lequel
la seconde source d'alimentation en gaz est adaptée pour alimenter le gaz stable vers la chambre de formation de film (11) pendant le temps d'attente avant la formation du film barrière aux gaz.

5. Dispositif de formation de film (100) selon la revendication 1 ou 2, comprenant en outre :
une électrode externe (55) qui est disposée dans la chambre de formation de film (11) et loge le récipient (P) ; et
une électrode interne (50) qui est adaptée pour être insérée dans et retirée du récipient (P) logé dans l'électrode externe (55), et pour conduire le milieu gazeux (G) jusque dans le récipient (P), dans lequel
l'électrode interne (50) constitue le tuyau d'alimentation en gaz (20).

6. Procédé de formation de film, comprenant les étapes consistant à :
loger un récipient (P) dans lequel un film barrière aux gaz doit être formé, dans une chambre de formation de film (11) dans un état de vide ; et
conduire un milieu gazeux (G) utilisé pour une formation du film barrière aux gaz, jusque dans le récipient (P) pour former le film barrière aux gaz, dans lequel le procédé de formation de film incluant
un état de formation de film dans lequel un tuyau d'alimentation en gaz (20) est inséré dans le récipient (P) logé dans la chambre de formation de film (11) et le milieu gazeux (G) est alimenté vers le récipient (P) à travers un trajet d'écoulement de gaz (23), le tuyau d'alimentation en gaz (20) incluant le trajet d'écoulement de gaz (23) qui conduit le milieu gazeux (G) jusque dans le récipient (P), et le tuyau d'alimentation en gaz (20) étant déplacé vers le haut et vers le bas le long d'une direction axiale, et
un état d'attente dans lequel le tuyau d'alimentation en gaz (20) continue à alimenter le milieu gazeux (G) vers la chambre de formation de film (11) pendant une période de temps prédéterminée après la fin de la formation du film barrière aux gaz, puis le tuyau d'alimentation en gaz (20) est rétracté à partir de la chambre de formation de film (11) et le trajet d'écoulement de gaz (23) est maintenu dans un état de décompression ;
dans lequel le trajet d'écoulement de gaz (23) est maintenu dans l'état de décompression par décompression d'une chambre de décompression (43) dans l'état d'attente, la chambre de décompression (43) communiquant avec le trajet d'écoulement de gaz (23) du tuyau d'alimentation en gaz (20) ;
dans lequel un logement (40) incluant la chambre de décompression (43) dans laquelle le tuyau d'alimentation en gaz (20) est déplacé vers le haut et vers le bas, est en outre pourvu, et
le tuyau d'alimentation en gaz (20) est inséré dans et retiré du récipient (P) à travers une chambre (10) qui entoure la chambre de formation de film (11) ;
dans lequel un dispositif de chauffage (30) supporté par le tuyau d'alimentation en gaz (20) est en outre pourvu, et
le dispositif de chauffage (30) est inséré dans et retiré du récipient (P), après l'insertion et l'extraction du tuyau d'alimentation en gaz (20).

7. Procédé de formation de film selon la revendication 6, dans lequel la communication entre la chambre de formation de film (11) et la chambre de décompression (43) est bloquée lorsque le tuyau d'alimentation en gaz (20) est rétracté à partir de la chambre de formation de film (11).

8. Procédé de formation de film selon la revendication 6 ou 7, dans lequel un gaz stable pour la formation du film barrière aux gaz est alimenté vers la chambre de formation de film (11) pendant un temps d'attente avant la formation du film barrière aux gaz.

9. Procédé de formation de film selon les revendications 6 à 8, dans lequel
une électrode externe (55) et une électrode interne (50) sont en outre pourvues, l'électrode externe (55) étant disposée dans la chambre de formation de film (11) et logeant le récipient (P), et l'électrode interne (50) étant insérée dans et retirée du récipient (P) logé dans l'électrode externe (55) et conduisant le milieu gazeux (G) jusque dans le récipient (P), et
l'électrode interne (50) constitue le tuyau d'alimentation en gaz (20).
